# EUROPEAN PATENT SPECIFICATION

(11) **EP 0 314 376 B1**
(45) Date of publication and mention of the grant of the patent: **04.01.1995**
(21) Application number: 88309787.5
(22) Date of filing: 19.10.1988
(51) Int. Cl.: H01L 23/52, H01L 27/04

(54) **Master slice type integrated circuit device and method of using it**
Integriertes Schaltkreis-Bauelement vom Typ "Master Slice" und dessen Verwendung
Dispositif de circuit intégré du type "master slice" et son utilisation

(30) Priority: 22.10.1987 JP 267065/87; 22.10.1987 JP 267066/87; 22.10.1987 JP 267067/87; 30.10.1987 JP 276214/87; 13.06.1988 JP 145156/87
(43) Date of publication of application: 03.05.1989
(73) Proprietor: Matsushita Electronics Corporation, Kadoma-shi, Osaka 571 (JP)
(72) Inventor: Fukui, Yuko, Otsu-shi Shiga-ken (JP); Ohtani, Katsuhiro, Kyoto-shi Kyoto (JP); Miyamoto, Hiroyuki, Fushimi-ku Kyoto-shi Kyoto (JP); Nishiura, Masao, Takatsuki-shi Osaka (JP); Chimura, Moriyuki, Ohe Nishikyo-ku,Kyoto-shi Kyoto (JP)
(74) Representative: Crawford, Andrew Birkby

(56) References cited:
- EP-A- 0 210 397
- US-A- 4 197 555
- PATENT ABSTRACTS OF JAPAN vol. 7, no. 136(E-181)(1281), 14th June 1983; JP-A-58 51537
- PATENT ABSTRACTS OF JAPAN vol. 6, no. 264(E-150)(1142), 23 December 1982; JP-A-16 0144
- PATENT ABSTRACTS OF JAPAN vol. 10, no. 79 (E-391)(2136), 28 March 1986; JP-A-60 224 243
- PATENT ABSTRACTS OF JAPAN vol. 6, no. 160 (E-126)(1038) 21 August 1982; JP-A-57 79647

## Description

This invention relates to a master slice type integrated circuit device and a manufacturing method thereof for electrically connecting plural logic function cells depending on the required circuit configuration after preparing multiple logic function cells integrated on a semiconductor substrate as a so-called master slice.

As the number of transistors integrated in a semiconductor device increases, semiconductor processing technology becomes more complicated, and a longer period is need for production. In the layout design of such devices, meanwhile, computer aided design (CAD) apparatus have been employed in order to cope with the complicated layout processing, and wiring of electrical connections is automated.

Patent Abstracts of Japan, Vol. 7, No. 136, (E-181)[1281], 14/06/83 (Seto) discloses a master slice chip in which adjacent element regions are coupled by means of buried wiring layers between the element regions. With the wiring layer divided into two segments, potential usage of the wiring layer to connect nodes of the element regions electrically can be doubled by choosing suitable points at which to make contacts.

Further Patent Abstracts of Japan, Vol. 10, No. 79, (E-391)[2136], 28/03/1986 (Fukuda) discloses a method of manufacture of a gate array type semiconductor integrated circuit device, which allows the chip to be made more compact. By forming three wiring layers above each chip area, the layers being connected to each other by through holes, it is possible to omit wiring channels.

Further methods of facilitating wiring between semiconductor elements, using multi-layer wiring in regular or irregular layouts are disclosed in EP-A-0199875 (Nishi), Patent Abstracts of Japan Vol. 6, No. 264, (E-150)[1142] (Tanizawa), and Patent Abstracts of Japan Vol. 6, No. 160, (E-126)[1038] (Miyazawa).

Finally, EP-A-0210397 (Aipperspach) discloses a standardized cell layout for large-scale integrated circuits with two layers of generally parallel conductors, those of one layer orthogonal to those of the other layer, wherein connections are made between the layers and connections are cut between points on the higher level conductor segments by means of selective laser welding and laser cutting.

There are thus the dual problems of providing a master slice chip in which only a final layer of wiring needs to be added after mass production of the master slice chip in order to personalize it for a specific purpose, while reducing the area of the wiring region required to form the required amount of electrical connections.

It is hence a primary object of this invention to provide a master slice type integrated circuit device capable of solving the above-discussed problems. The construction of a master slice type integrated circuit device according to the present invention is defined in claim 1.

According to this invention, since the processing up to the step of forming contact holes in the insulation layer on the wiring pieces can be carried out in the same way for all circuits, mass production is possible. Furthermore, the processing in order to realize individual circuits on a semiconductor substrate is finished merely by the wiring of one layer after the above-mentioned step, so that the term of development may be greatly shortened.

The present invention therefore further provides a method of manufacturing an integrated circuit device making use of a master slice type integrated circuit device according to the present invention and comprising the steps as set out in claim 3.

While the novel features of the invention are set forth in the appended claims, the invention, both as to organization and content, will be better understood and appreciated, along with other objects and features thereof, from the following detailed description taken in conjunction with the drawings.

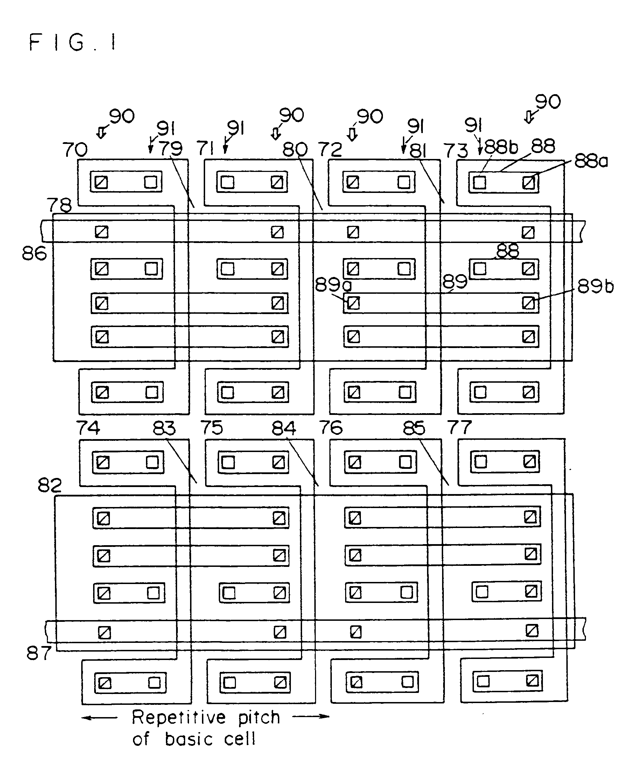

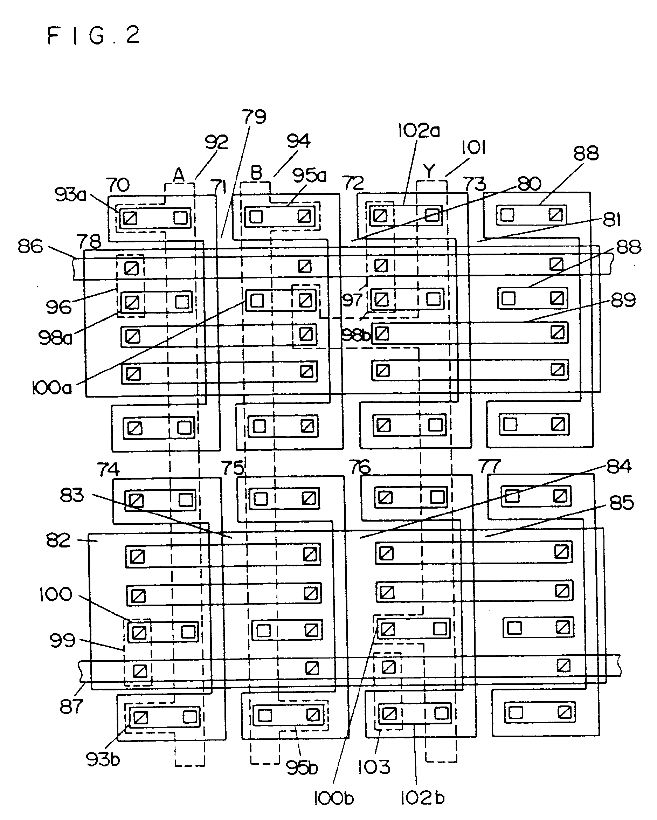

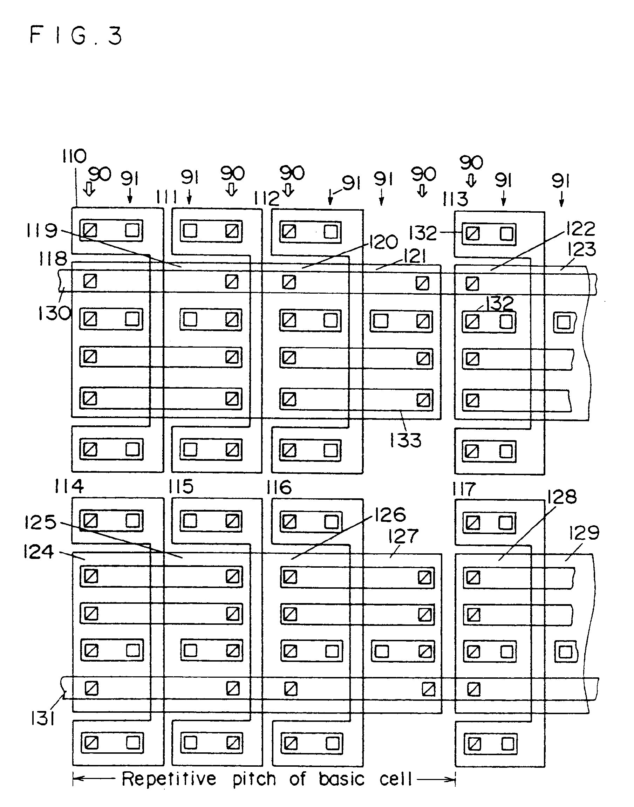

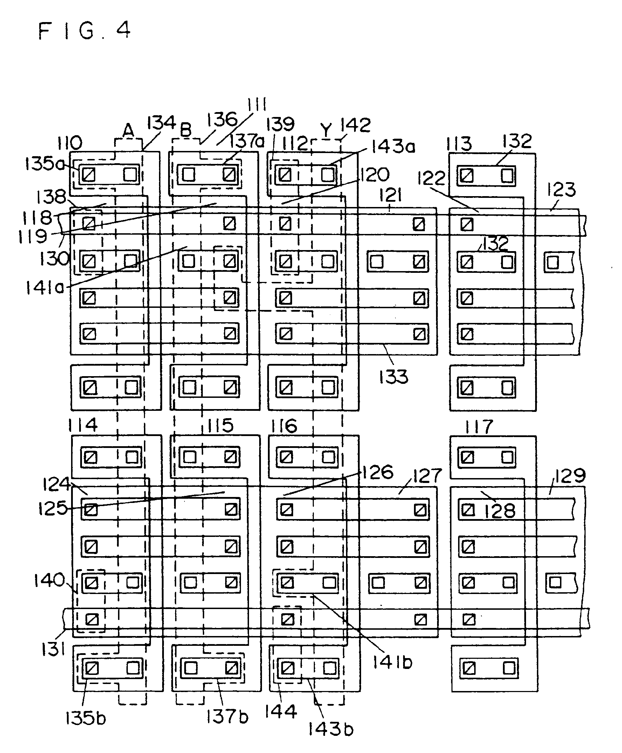

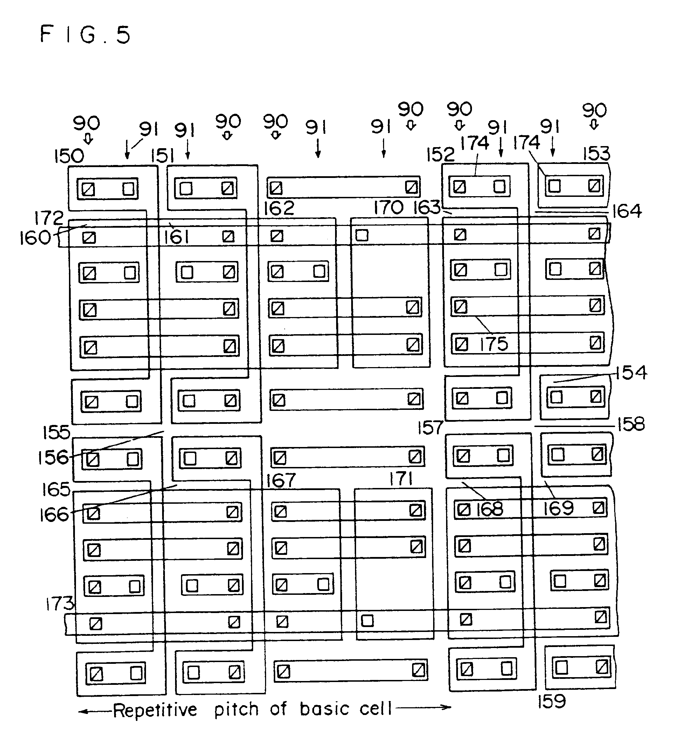

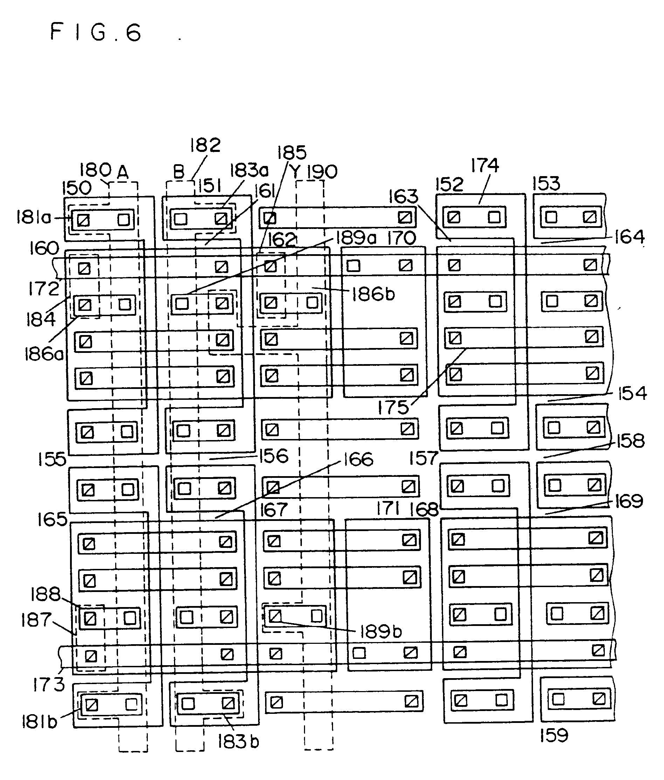

Fig. 1 to Fig. 6 are drawings to explain an embodiment of this invention, in which Fig. 1 is a layout drawing of a master slice of which basic cell is composed of two-input gate isolation type; Fig. 2 is a plan view in a state of forming macrocell by wiring on the master slice shown in Fig 1; Fig. 3 is a layout drawing of a master slice of which basic cell is composed of three-input oxide isolation type; Fig. 4 is a plan view in a state of forming macrocell by wiring on the master slice shown in Fig. 3; Fig. 5 is a layout drawing of a master slice of which basic cell is composed of two-input oxide isolation type; and Fig. 6 is a plan view in a state of forming macrocell by wiring on the master slice shown in Fig. 5; and

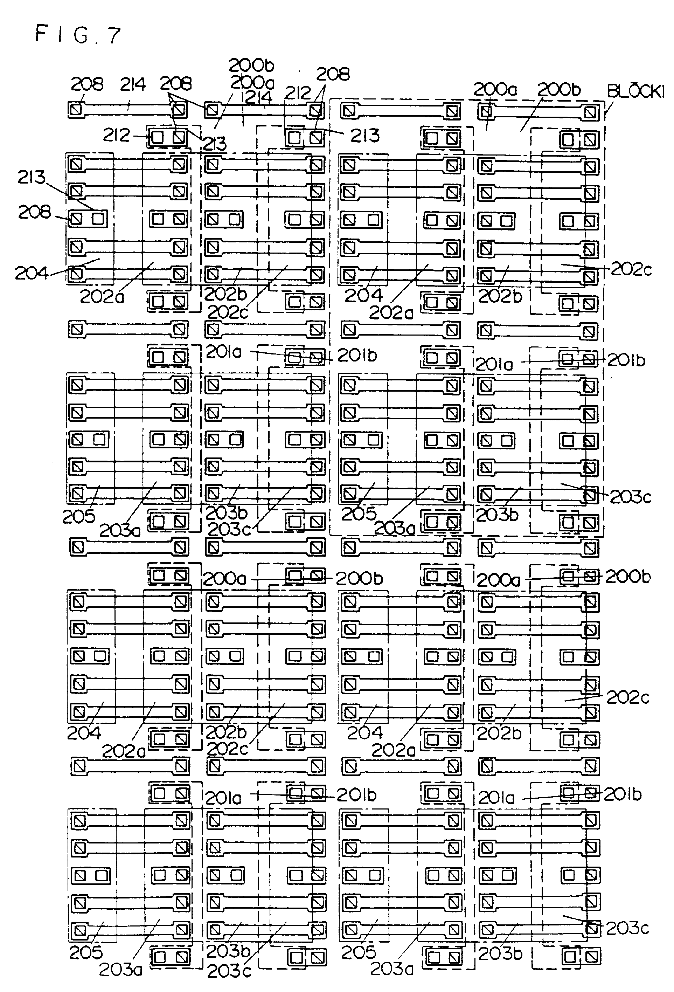

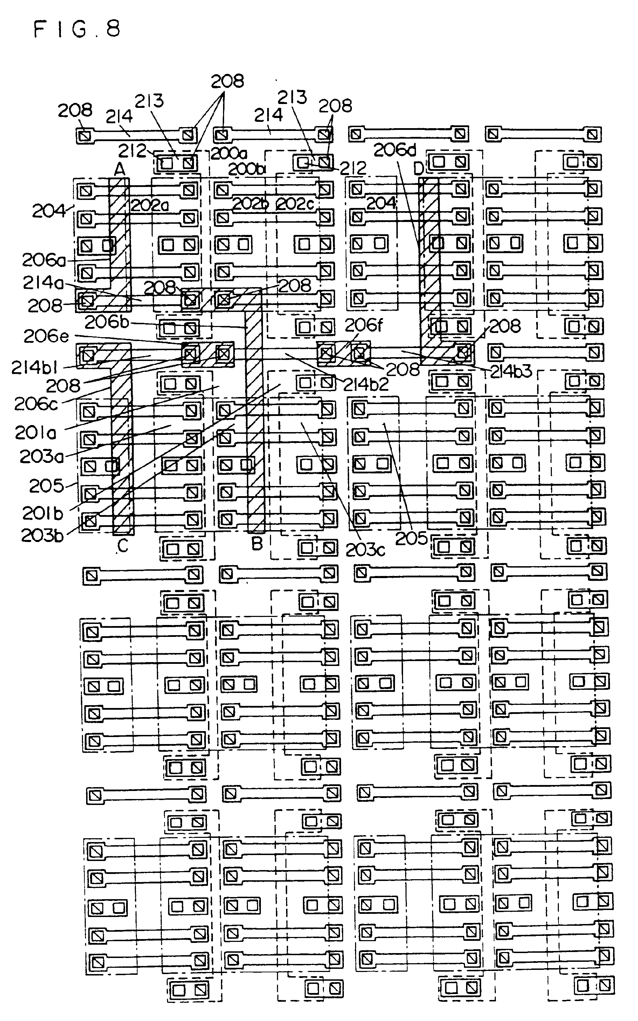

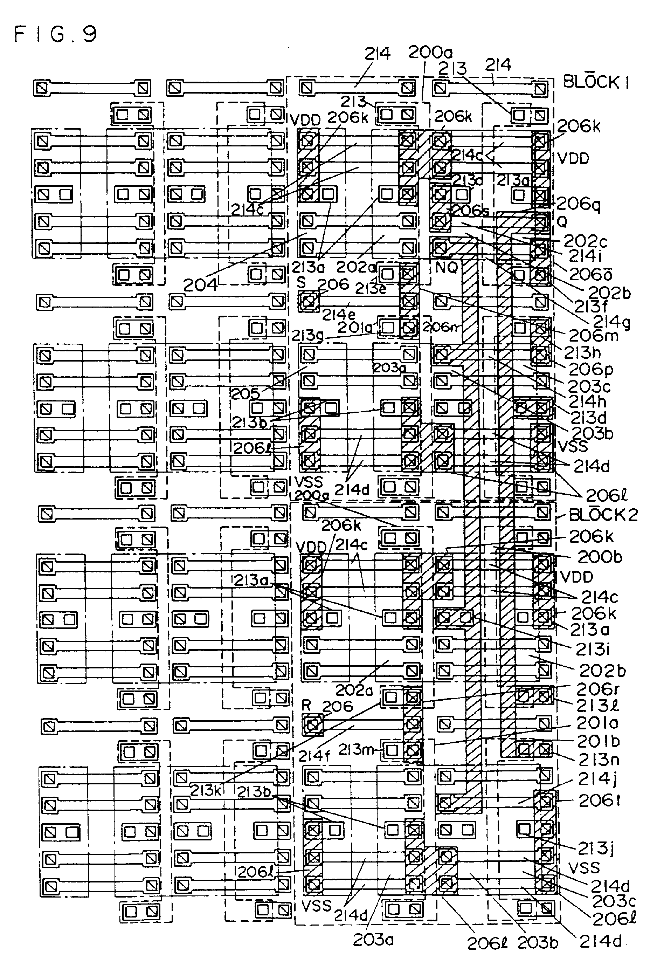

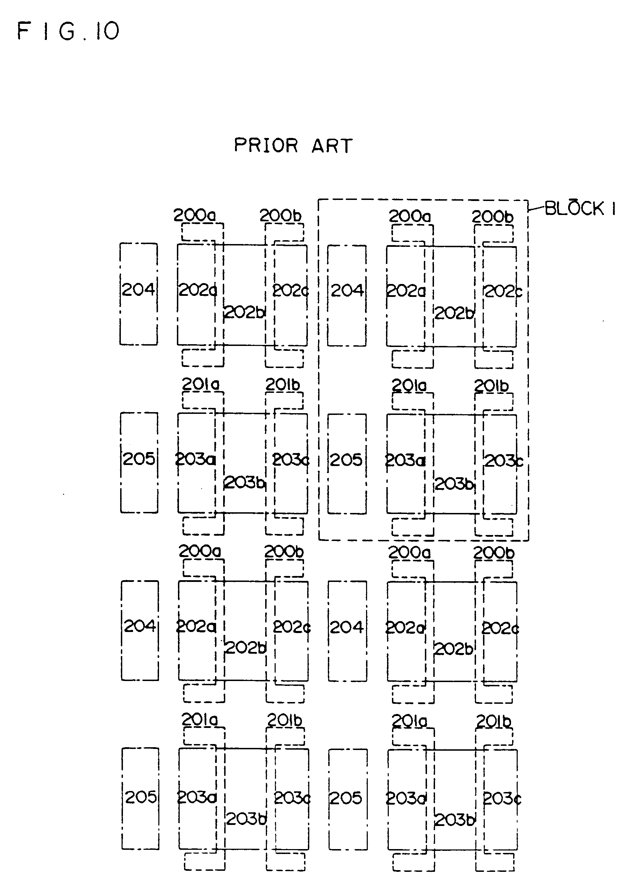

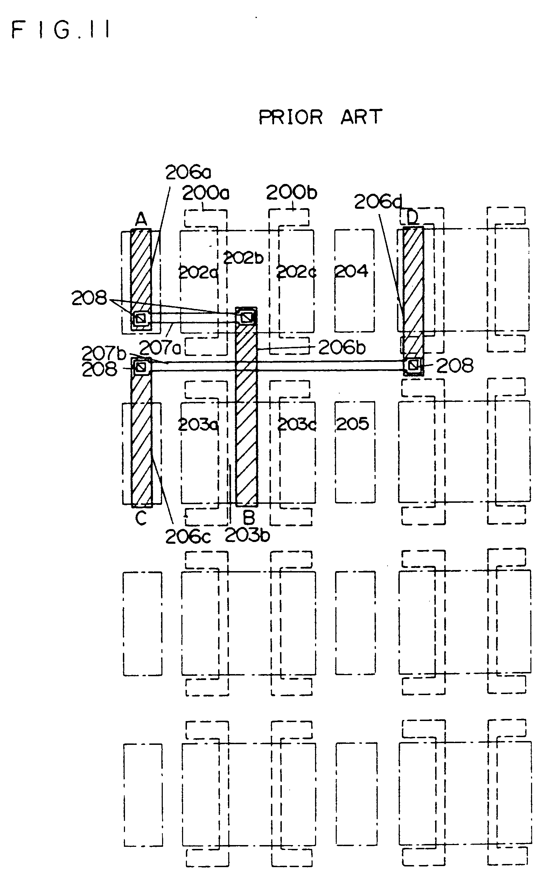

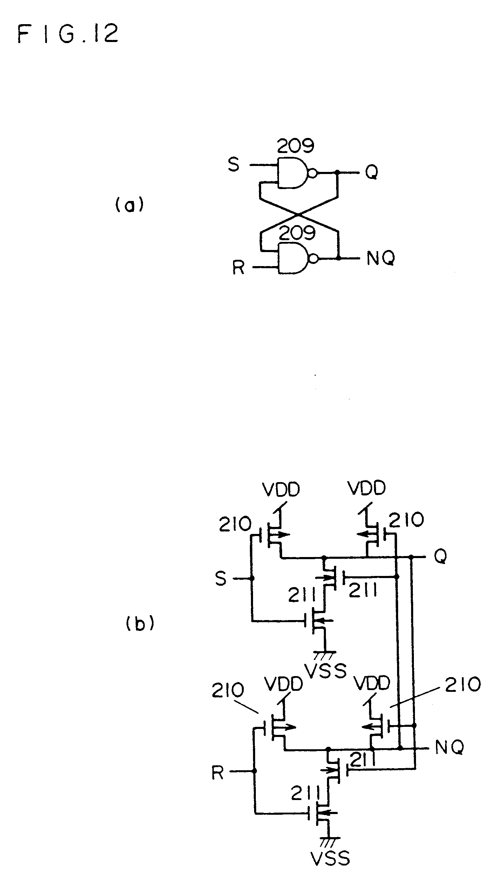

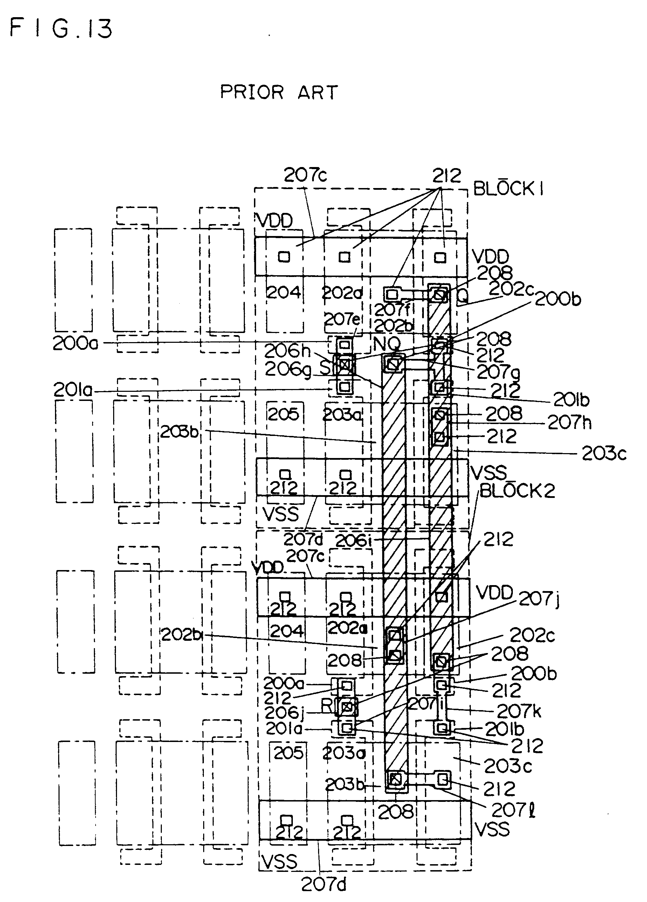

Fig. 7 to Fig. 13 are drawings to explain a further embodiment of this invention, in which Fig. 7 is a plan view showing an entire surface element forming part of a master slice of a master slice type integrated circuit device according to the embodiment of this invention; Fig. 8 is a plan view showing a wiring example in the embodiments shown in Fig. 7; Fig. 9 is a plan view of composing an R-S latch circuit shown in Fig. 12 (a), (b) on the master slice in the embodiment in Fig. 7; Fig. 10 is a plan view showing an entire surface element forming part of a master slice in a method of employing the master slice in the process up to the step of forming transistor elements in the prior art; Fig. 11 is a plan view showing a wiring example in the prior art in Fig. 10; Fig. 12(a), (b) are drawings to show the R-S latch circuit and its transistor composition; and Fig. 13 is a plan view showing the composition of the R-S latch circuit shown in Fig. 12(a), (b) on the master slice in the prior art showing in Fig. 10 in the conventional method.

Figs. 1 to 6 show an embodiment of this invention capable of directly utilizing the basic part of such grid wiring technique.

Fig. 1 shows a pattern of a master (before final wiring formation) of basic element group (called basic cell) of master slice type CMOS integrated circuit device, in which the pattern for the portion of two units of the basic cell is shown. Numerals 70 to 73 are gate electrodes of P-channel transistor (called P-chTr), 74 to 77 are gate electrodes of N-channel transistor (called N-chTr), 78 to 81 are P⁺ diffusion regions for forming source or drain, 82 to 85 are N⁺ diffusion regions for forming source or drain, 86 is a VDD power source wire, and 87 is a VSS power source wire. Numeral 88 denotes a first one of first layer wiring pieces having a through hole 88b at one end and a contact hole 88a at the other end, formed on at least one of all gates sources and drains. And 89 is a second one of first layer wiring pieces having contact holes 89a, 89b at both ends, and is of a length such that contact holes 89a, 89b are disposed at opposite ends of the repetitive pitch of the basic cell. The contact hole 88a on the first layer wiring piece 88 is formed on a first track 90. The contact hole 89b lies on the same first track and contact hole 89a lies on a parallel first track while the through hole 88b is formed on a second track 91 not including contact holes.

In fact, however, the through hole 88b is formed in the insulation layer between the semiconductor substrate surface and the first layer wiring pieces 88, and the contact holes 88a, 89a, 89b are formed in the insulation layer on the first layer wiring pieces 88, 89. But for the sake of simplicity of explanation, such relation is expressed here such as "to have though hole 88b at one end of first layer wiring piece 88" or "to have contact holes 89a, 89b at both ends of first layer wiring piece 89".

Fig. 2 shows an embodiment of a macrocell formed from the above-described master slice in which a two-input NAND gate is shown. Numerals 70 to 89 are same as those shown in Fig. 1. An input signal A is connected to the gate electrode 70 of P-chTr and the gate electrode 74 of N-chTr by way of first layer wiring pieces 93a, 93b from second layer wiring 92 respectively. An input signal B is similarly connected to the gate electrode 71 of P-chTr and the gate electrode 75 of N-chTr by way of first layer wiring pieces 95a, 95b from second layer wiring 94 respectively. By the second layer wirings 96, 97, and first layer wiring pieces 98a, 98b, P⁺ diffusion regions 78, 80 are connected to a VDD power source wire 86 to become the source of P-chTr. By the second layer wiring 99 and first layer wiring piece 100, N⁺ diffusion region 82 is connected to the VSS power source wire 87 to become the source of N-chTr. The P⁺ diffusion region 79 is connected to the second layer wiring 101 by way of the first layer wiring piece 100a, and the N⁺ diffusion region 84 is connected to the same second layer wiring 101 by way of the first layer wiring piece 100b. As a result, the drain of P-chTr and the drain of N-chTr are mutually connected, and the second layer wiring 101 becomes the output terminal of output signal Y. By the first layer wiring pieces 102a, 102b and the second layer wirings 97, 103, the gate electrodes 72, 76 are respectively connected to the VDD power source wire 86 and VCC power source wire 87. As a result, the channel regions of P-chTr and N-chTr are turned off, the conduction with the right side diffusion regions is cut off individually.

In this way, the two-input NAND gate is composed.

For example, an embodiment of this invention by basic cell in oxide isolation structure is described below. Fig. 3 is a master layout in which basic cells are in three-input oxide isolation structure, wherein 110 to 113 are gate electrodes of P-chTr, 114 to 117 are gate electrodes of N-chTr, 118 to 123 are P⁺ diffusion regions, 124 to 129 are N⁺ diffusion regions, 130 is a VDD power source wire, and 131 is a VSS power source wire. Numeral 132 is a first one of the first layer wiring pieces in the same shape as the one indicated by numeral 88 in Fig. 1. Numeral 133 is a second one of the first layer wiring pieces in the same shape as the one indicated by numeral 89 in Fig. 1. The second first layer wiring piece 133 has a contact hole at each end, and is long enough to span the width of two wires of the second layer wirings which are insulated therefrom by insulation layer (not shown) on the first layer wiring piece 133, and two pieces are formed in one basic cell in the lengthwise direction of the first layer wiring piece 133.

Fig. 4 shows an embodiment of a macrocell formed from the master slice shown in Fig. 3, in which a two-input NAND gate is produced. An input signal A is connected to the gate electrode 110 of P-chTr and the gate electrode 114 of N-chTr through first layer wiring pieces 135a, 135b from the second layer wiring 134, while an input signal B is similarly connected to the gate electrode 111 of P-chTr and the gate electrode 115 of N-chTr through first layer wiring pieces 137a, 137b from the second layer wiring 136. By the second layer wirings 138, 139, P⁺ diffusion regions 118, 120 are connected to a VDD power source wire 130 to become the source of P-chTr. By means of the second layer wiring 140, N⁺ diffusion region 124 is connected to a VSS power source wire 131 to become the sourse of N-chTr. The P⁺ diffusion region 119 is connected to the second layer wiring 142 through the first layer wiring piece 141a, and the N⁺ diffusion region 126 is connected to the same second layer wiring 142 through the first layer wiring piece 141b. As a result, the drain of P-chTr and the drain of N-chTr are mutually connected, and the second layer wiring 142 becomes the output terminal of output signal Y. In addition,by means of the first layer wirings 143a,143b and the second layer wirings 139, 144, the gate electrodes 112, 116 are respectively connected to the VDD power source wire 130 and VSS power source wire 131. In this constitution, the channel regions of P-chTr and N-chTr are turned off, and the diffusion regions 120, 126 are separated from the right-side diffusion regions, respectively.

As another example of basic cell differing in structure, a two-input gate isolation structure is explained below. Fig. 5 shows a master layout of two-input gate isolation structure, in which numerals 150 to 154 are gate electrodes of P-chTr, 155 to 159 are gate electrodes of N-chTr, 160 to 162, 163, 164 are P⁺ diffusion regions, 165 to 167, 168, 169 are N⁺ diffusion regions, 170 is N⁺ diffusion region in N-type substrate or N-type islet region, and 171 is P⁺ diffusion region of N-type substrate or P-type islet region. The diffusion regions 170 and 171 are disposed in order to prevent latch-up and stabilize the AC characteristics, and at the same time the upper parts thereof are utilized as the feed-through regions for routing the second layer wirings. Numeral 172 is a first layer wiring for the VDD power source and 173 is a first layer wiring for the VSS power source. Numeral 174 is a first layer wiring piece in the same shape as the one indicated by 88 in Fig. 1, and 175 is a first layer wiring piece in the same shape as the one indicated by 133 in Fig. 3, and two pieces 175, 175 are formed in one basic cell in the lengthwise direction of the first layer wiring piece 175, same as in 133 in Fig. 15.

Fig. 6 is a drawing realizing a macrocell on the master slice in the structure shown in Fig. 5 , and a two-input NAND gate is composed same as in the preceding example. An input signal A is connected to the gate electrode 150 of P-chTr and the gate electrode 155 of N-chTr through first layer wiring pieces 181a, 181b from the second layer wiring 180, and an input signal B is connected to the gate elctrode 151 of P-chTr and the gate electrode 156 of N-chTr through first layer wiring pieces 183a, 183b from the second layer wiring 182. By the second layer wirings 184, 185 and first layer wiring pieces 186a, 186b, P⁺ diffusion regions 160, 162 are connected to the VDD power source wire 172 to become the source of P-chTr. By means of the second layer wiring 187 and first layer wiring piece 188, N⁺ diffusion region 165 is connected to the VSS power source wire 173 to become the source of N-chTr. Then the P⁺ diffusion region 161 is connected to the second layer wiring 190 through the first layer wiring piece 189a, while the N⁺ diffusion region 167 is connected to the second layer wiring 190 by way of the first layer wiring piece 189b. As a result, the drain of P-chTr and the drain of N-chTr are mutually connected, and the second layer wiring 190 becomes the output terminal of output signal Y. Thus, the two-input NAND gate is composed on the master slice in the two-input gate isolation structure.

In all of Figs. 1 to 6 explained so far, the contact holes on the first one of first layer wiring pieces and the contact holes on the second one of the first layer wiring pieces are formed only on the first tracks 90 in which the contact holes can be formed. Accordingly, using these first tracks 90 as the tracks for feed-through, and the second layer wiring running between the first tracks 90 can be fed straightly. Therefore, it is not necessary to use any particular wiring region for the second layer wiring in within the basic cell units and the chip area can be reduced accordingly.

Also, in any one of Figs. 1 to 6, since the tracks at both ends of the repetitive pitch of the basic cell are used as the first tracks 90 for forming contact holes, the second layer wiring for connecting first layer wiring pieces between adjacent basic cells can be set at its shortest.

Furthermore, in all of Figs. 1 to 6, since the through holes for connecting each node of the transistor elements and the first one of the first layer wiring pieces are formed only on the second tracks 91 on which formation of contact holes is prohibited, various logic functions may be realized by forming the second layer wirings on the first tracks 90 and second tracks 91 by employing the conventional grid wiring technique.

Moreover, even if the second layer wiring in the direction orthogonal to the first layer wiring pieces cannot be formed between adjacent second pieces of the first layer wiring pieces, since two tracks are independently maintained above the first one of the first layer wiring pieces, wiring is possible with almost the same degree of freedom as in the conventional two-layer wiring method. Above all, when the second one of the first layer wiring pieces is set in an exact length sufficient to span the width of two electrically independent main elongate portions of the second layer wiring the length of the first one of the first layer wiring pieces can be set at its shortest without sacrificing a degree of freedom of wiring, and accordingly, the length of the second one of the first layer wiring pieces can be shortened. As a result, wiring efficiency in the cell is enhanced, and the chip area can be reduced.

Meanwhile, as for the number of inputs of the basic unit cells, two-input type and three-input type are shown in the embodiment, but this invention may be realized in any number of inputs.

In the foregoing embodiments, a CMOS type semiconductor integrated circuit device is illustrated, but this invention can be equally applied into NMOS, PMOS, bipolar, Bi-CMOS, GaAs, ECL and other master slice type integrated circuit devices differing in process or device, in the same manner as in CMOS.

In these embodiments, the two-input NAND gate is shown in a macrocell example, but it is also possible to compose three-input NAND, buffer, inverter, NOR and others by using this invention.

In Figs. 1 to 6, the basic cell is shown to have four second ones of the first layer wiring pieces, but it is also possible to compose more complicated circuits such as latches and flip-flops by increasing the number of second ones of the first layer wiring pieces.

Thus, in the embodiment of this invention, the first layer wiring formed in the master slice step is composed of first ones of first layer wiring pieces having a through hole at one end and a contact hole at the other end, and second ones of first layer wiring pieces having contact holes at both ends, and each contact hole is formed on a first track, on which contact holes can be formed, orthogonally crossing with the first layer wiring pieces. Therefore, a first track may be used as the track for feed-through, parallel to which a second layer wiring can run in a straight line, between cells so that an increase of the chip area can be reduced.

Referring now to Figs. 7 to 13 a further embodiment of this invention is described below. The further embodiment is intended to realize the final circuit by forming transistor elements on almost the entire surface of a semiconductor substrate, fabricating a master slice by finishing the process up to the steps of forming general-purpose wiring pieces of lower layer thereon and forming through holes thereon, and then wiring only the top layer depending on the individual circuits.

Fig. 10 is a plan view showing a part of a full surface element master slice in an example of a prior art method employing a master slice in the process up to the formation of transistor elements, showing a pattern of four basic units (the extent of one basic unit being designated BLOCK 1) of the element group formed on almost the entire surface of the semiconductor substrate. In this drawing, 200a and 200b are gate electrodes of a P-channel transistor (P-chTr), 201a and 201b are gate electrodes of an N-channel transistor (N-chTr), 202a, 202b, 202c are source or drain regions of a P-chTr, 203a, 203b, 203c are source or drain regions of an N-chTr, 204 is an N⁺ diffusion region in the substrate of a P-chTr, and 205 is a P⁺ diffusion region in the substrate of an N-chTr. Two P-chTrs and two N-chTrs are used as one basic unit of element group, and the product of forming this basic unit on almost the entire surface of the semiconductor substrate is a master slice.

Fig. 11 shows a wiring example for realizing an required circuit in the conventional two-layer wiring method. Here, the technique is explained by a simple wiring example of connecting A and B, and C and D in Fig. 11.

In Fig. 11, 200a to 205 are same as in Fig. 10 and 206a to 206d are wirings formed by second wiring conductive layers. For multilevel crossing of plural different signal wires, the method of crossing the main wiring direction of lower layer wiring and the main wiring direction of upper layer wiring orthogonally is common in automatic multi-layer wiring, and in Fig. 11 the main wiring direction of the lower layer wiring is set in the horizontal direction, and the main wiring direction of the upper layer wiring is set in the perpendicular direction. In the following description, the conductive layer for first wiring means the lower layer wiring layer, and the conductive layer for second wiring indicates the upper layer wiring layer.

In the wiring method in the prior art, shown in Fig.11 wiring of A and B is achieved by upper layer wiring 206a, lower layer wiring 207a, and upper layer wiring 206b, and wiring of C and D is achieved by upper layer wiring 206c, lower layer wiring 207b, and upper layer wiring 206d, and a necessary connection is realized as the upper layer wiring 206b between A and B, the lower layer wiring 207b between C and D cross with each other at different levels by way of an insulation layer (not shown). Meanwhile, at both ends of the lower layer wirings 207a, 207b, contact holes 208a formed in an insulation layer (not shown) are positioned respectively, and by way of these contact holes 208, the upper layer wirings 206a to 206d and lower layer wirings 207a, 207b are connected.

In relation to an example of simple logic circuit, the conventional method of realizing a required circuit on a master slice is explained while referring to Figs. 12 and 13.

Fig. 12(a) shows an R-S latch circuit illustrated as an example of logic circuit, and Fig. 12(b) is a drawing showing its transistor configuration. Numeral 209 is a two-input NAND gate, 210 is a P-channel P-ch transistor, 211, is an N-channel (N-ch) transistor, S, R are input signals, Q,NG are output signals and VDD, VSS are power sources.

Fig.13 is a plan view of the construction of the R-S latch circuit in Fig. 12 (b) on the master slice shown in Fig. 10. In Fig. 13 , 200a to 208 are same as those in Fig. 10. Numeral 212 is a through hole for connecting each node of the semiconductor element to the first layer wirings, 207e to 207ℓ are first layer wirings, of which 207c is VDD power source wiring, 207d is VSS power source wiring, and 207e to 207ℓ are other signal wirings. Numeral 208 is a contact hole formed in the insulation layer (not shown) for connecting first layer wirings to the second layer wirings, 206g to 206j are second layer wirings formed or said insulation layer, S, R are input signals, Q, NQ are output signals, VDD, VSS are power sources, BLOCK1, BLOCK2 designate the extent respective basic units of element group formed almost on the entire surface of the semiconductor substrate in the master slice process. The R-S latch circuit in Fig. 12 (b) is composed of four P-ch transistors and four N-ch transistors, but in the example in Fig. 13, this R-S latch circuit is composed in the smallest region to satisfy the necessary number of transistors for this composition, that is, in the range of two basic units of BLOCK1 and BLOCK2.

Practical wirings are explained below. The VDD power source is connected to the source regions 202a, 202c of P-ch transistor and N⁺ diffusion region 204 in the substrate of the P-ch transistor in the basic units of BLOCK1, BLOCK2 respectively by way of the VDD power source wiring 207c and through holes 212. The VSS power source is connected to the source region 203a of an N-ch transistor and P⁺ diffusion region 205 in the substrateof an N-ch transistor in the basic units of BLOCK1, BLOCK2 respectively by way of the VSS power source wiring 207d and through holes 212. An input signal S is connected to the gate electrode 200a of an N-ch transistor and the gate electrode 201a of a P-ch transistor in BLOCK1 by way of the second layer wiring 206g, contact hole 208, the first layer wiring 207e and through holes 212 formed on both ends of the first layer wiring 207e. An input signal R is connected to the gate electrode 200a of a P-ch transistor and the gate electrode 201a of an N-ch transistor in BLOCK2 by way of the second layer wiring 206j, contact hole 208, the first layer wiring 207i and the through holes 212 formed on both ends of the first layer wiring 207i. An output signal Q is delivered from the drain region 202b of a P-ch transistor and the drain region 203c of an N-ch transistor in BLOCK1 by way of through holes 212, the first layer wiring 207f, 207h, contact holes 208 and the second layer wiring 206i. At the same time, the output signal Q is connected to the gate electrode 200b of a P-ch transistor and the gate electrode 201b of an N-ch transistor in BLOCK2 by way of through holes 212, the first layer wiring 207k, contact hole 208 and the second layer wiring 206i. An output signal NQ is delivered from the drain region 202b of a P-ch transistor and the drain region 203c of an N-ch transistor in BLOCK2 by way of through holes 212, the first layer wiring 207j, 207ℓ, contact holes 208 and the second layer wiring 206h. At the same time, the output signal NQ is connected to the gate electrode 200b of a P-ch transistor and the gate electrode 201b of an N-ch transistor in BLOCK1 by way of through holes 212, the first layer wiring 207g, contact holes 208 and the second layer wiring 206h. By means of this wiring construction, the R-S latch circuit in the transistor configuration as shown in Fig. 12 (b) can be formed on the master slice.

However, in the conventional wiring method shown in Figs. 11,13, four steps are needed until completion of wiring, that is, a step of forming through holes on transistor elements, a step of forming first layer wiring, a step of forming contact holes in the insulation layer between the first layer wiring and the second layer wiring, and a step of processing the second layer wiring. Therefore, if an automatic technique for wiring design using computer processing is employed, the subsequent wiring processing steps during manufacture cannot be shortened, and the term for delivery after completion of logic design cannot be reduced.

The embodiment of this invention shown in Figs. 7 to 9 is intended to solve the above-discussed problems in the prior art. That is, the master slice type integrated circuit device and its manufacturing method according to this invention are capable of significantly shortening the period for development and manufacture of required semiconductor integrated circuits. The invention is applied to the master slice of the so-called full surface element forming type in which transistor elements are formed on almost the entire surface of the semiconductor substrate.

Figure 7 is a plan view showing a full surface element forming part of a master slice in the master slice type integrated circuit device according to this invention, showing in particular the pattern of the parts of four basic units where the extent of one basic unit is designated BLOCK1, of the element group formed on almost the entire surface of the semiconductor substrate. Numerals 200a to 205 are same as those shown in Fig. 10 Numeral 212 is a through hole into each node of the semiconductor elements, 213 is a first one of the first layer wiring pieces, 214 is a second one of the first layer wiring pieces, and 208 is a contact hole formed in the insulation layer (not shown) in order to connect the first layer wirings to the second layer wirings. In this embodiment, a step of forming transistor elements, through holes in the insulation layer on the transistor elements, the first layer wirings on said insulation layer, and contact holes formed in the insulation layer on the first layer wirings, and the resulting assembly comprises a master slice. The first one of the first layer wiring piece 213 is provided in order to connect each node of the transistor elements to the second layer wiring by way of through hole 212 and contact hole 208, and the second one of the first layer wiring piece 214 can be connected to the second layer wiring by way of the contact holes 208 at its both ends, and the second layer wirings are designed to be able to cross above the second one of the first layer while being kept independent electrically. In this state of the master slice, the first and second ones of the first layer wiring pieces 213, 214 are electrically independent of other wirings, and a versatile lower layer wiring structure is realized.

This embodiment is hence intended to realize a desired integrated circuit by finishing the master slice manufacturing step by forming the through holes, the versatile lower layer wiring pieces and contact holes, and then mutually connecting the required semiconductor elements in the step of forming the upper (second) layer wirings alone.

A practical wiring example for realizing a desired circuit by means of the upper (second) layer wirings alone is explained below. Here, as in the conventional example in Fig. 11, a simple technique of wiring for connecting A and B, and C and D in Fig. 8 is illustrated.

Fig. 8 is a plan view showing the wiring method in the master slice method of this embodiment, and it corresponds to the plan view showing the wiring method in the conventional master slice method shown in Fig. 11.

In Fig. 8 , wiring of A and B is achieved by way of the first layer wiring piece 214a and the second layer wirings 206a and 206b, and wiring of C and D is achieved by way of the first layer wiring pieces 214b1, 214b2, 214b3, the second layer wirings 206c, 206d for bridge connection in the vertical direction and the second layer wiring pieces 206e, 206f for bridge connection in the horizontal direction, and a required connection is realized by crossing the second layer wiring 206b between A and B and the first layer wiring piece 214b2 between C and D by insulating by the insulating layer therebetween.

As shown in the wiring technique in Fig. 8, according to this embodiment, extending of the second layer wirings in the horizontal direction is achieved by forming bridge connections in the horizontal direction; wiring in the perpendicular direction is achieved by forming the second layer wirings above the first layer wiring pieces 214 in such a manner that they do not make contact with the contact holes; and exchange of horizontal wiring and perpendicular wiring is achieved by forming the second layer wirings with the inclusion of a portion above the contact holes. In this way wiring with high degree of freedom, as in the conventional two-layer wiring, can be achieved by additionally forming the second layer wirings. In addition, as is clear from this embodiment, by forming the first layer wiring pieces and contact holes in regular patterns, automatic processing of the second layer wiring is facilitated.

An example of a simple logic circuit, formed according to the method of the invention by realizing the desired circuit on a master slice is described below.

Fig. 9 shows the example of forming the R-S latch circuit of Fig. 12 (b) on the master slice of this embodiment which is illustrated in Fig. 7. In Fig. 9, 200a to 208 are same as those shown in Fig. 7, which are preliminarily formed in the master slice process. Numerals 206, 206k to 206t are second layer wirings, and the R-S latch circuit in Fig. 12 (b) is realized by additionally forming only these second layer wirings 206, 206k to 206t on the master slice shown in Fig. 7. Furthermore, S, R are input signals, Q, NQ are output signals, VDD, VSS are power sources, and BLOCK1, BLOCK2 show the extent of respective basic units of a group of elements formed on almost the entire surface on the semiconductor substrate in the master slice process. The R-S latch circuit in Fig. 12 (b) is composed of four P-channel (P-ch) transistors and four N-channel (N-ch) transistors, and in the embodiment of Fig. 9 in which the method of this invention is applied, the R-S latch circuit is formed in the smallest region having the sufficient number of transistors for this configuration, that is, in the area of two basic units BLOCK1 and BLOCK2.

The physical connection of the wirings is explained below. The VDD power source is connected to the source regions 202a, 202c of a P-ch transistor and N diffusion region 204 in the substrate of the P-ch transistor in the basic units BLOCK1, BLOCK2 respectively by way of three second layer wirings 206k formed in each of BLOCK1 and BLOCK2 respectively, the first one of the first layer wiring piece 213a and the second one of the first layer wiring piece 214c. The VSS power source is connected to the source region 203a of an N-ch transistor and the P⁺ diffusion region 205 in the substrate of an N-ch transistor in the basic units BLOCK1, BLOCK2 respectively by way of the three second layer wirings 206ℓ formed in each of BLOCK1 and BLOCK2 respectively, the first one of the first layer wiring piece 213b and the second one of the first layer wiring piece 214d. An input signal S is connected to the gate electrode 200a of a P-ch transistor and the gate electrode 201a of an N-ch transistor by way of the second layer wirings 206, 206m formed in BLOCK1, the first ones of the first layer wiring piece 213e, 213g and the second one of the first layer wiring piece 214e. An input signal R is connected to the gate electrode 200a of a P-ch transistor and the gate electrode 201a of an N-ch transistor by way of the second layer wirings 206, 206r formed in BLOCK2, the first ones of the first layer wiring piece 213k, 213m and the second one of the first layer wiring piece 214f. An output signal Q is delivered from the drain region 202b of an N-ch transistor and the drain region 203c or an N-ch transistor in BLOCK1 by way of the second layer wirings 206q, 206s, the first ones of the first layer wiring piece 213c, 213d and the second one of the first layer wiring piece 214i. At the same time, the output signal Q is connected to the gate electrode 200b of a P-ch transistor and the gate electrode 201b of an N-ch transistor in BLOCK2 by way of the second layer wiring 206q and the first ones of the first layer wiring piece 213ℓ, 213n. An output signal NQ is delivered from the drain region 202b of a P-ch transistor and the drain region 203c of an N-ch transistor in BLOCK2 by way of the second layer wirings 206n, 206t, the first ones of the first layer wiring 213i, 213j and the second layer wiring 214j. At the same time, the output signal NQ is connected to the gate electrode 200b of a P-ch transistor and the gate electrode 201b of an N-ch transistor in BLOCK1 by way of the second layer wirings 206o, 206p, the first ones of the first layer wiring piece 213f, 213h and the second ones of the first layer wiring 214g, 214h. In this wiring configuration, the R-S latch circuit in the transistor construction in Fig. 12 (b) may be composed on the master slice. In the master slice of the embodiment shown in Fig. 7 since the power source wiring is not fixed by the lower layer wiring, the lower layer wiring pieces at arbitrary positions may be used for either power source wiring formation or signal wiring formation, which is a structure suited to full surface element formation type.

As is evident from a comparison with the result of two-layer wiring using the conventional master slice method shown in Fig. 13, when the master slice of this embodiment is used, it is possible to obtain the same results of wiring connection as the conventional two-layer wiring, but with a high degree of freedom by only additionally forming the second layer wirings.

In the foregoing explanations, an R-S latch circuit composed of two-input NAND gates was described as an example of a circuit to be formed on the master slice, but since the master slice of this invention is of an extremely versatile type, the circuit that can be formed on the master slice is not limited to small logic circuits alone, flip-flop, a complicated logic function circuit, a so-called MSI function circuit, megamacro function circuit among others, can be equally easily formed. In other words, all the circuits that can be realized in conventional master slice methods comprising two layers of wiring in the later process, can be realized by only one additional process of wiring formation on one layer on the master slice of this invention.

Thus, according to the structure and manufacturing method of master slice type integrated circuit device of this invention, since the first step of forming through holes, first layer wiring pieces and contact holes in addition to the formation of transistor elements in the conventional method can be carried out regardless of the features of the eventual logic circuits, a common master slice can be mass-produced beforehand. What is more, final required circuits can be realized by forming only the second layer wirings depending on the individual circuits, so that the term for development and manufacture of semiconductor integrated circuits may be significantly shortened. Besides, fabrication of only one component - the glass mask used in the darkroom process in semiconductor device manufacture as required depending on an individual circuit - is sufficient, and it can be manufactured by means of the treatment process of the second layer wirings alone, and hence the development cost is reduced and therefore this invention is suitable for production of multiple types in small quantities.

In the foregoing embodiments, the fundamental transistor element group was of two-input structure in which two transistors shared the drain, and the structure for separating from the adjacent transistor element group was described as of oxide isolation type, but the application of this invention depends neither on the transistor composition nor the separation composition of the fundamental transistor element group. That is, the number of inputs in the fundamental transistor element group is immaterial, and, for example, three-input or four-input type may be applicable. Furthermore, this invention is also applicable to the transistor element group with an element separation composition of gate isolation type.

Also, in the preceding embodiments, 10 channels of the second layer wiring formal are in the horizontal direction within the region of the element group of one basic unit, but the application of this invention does not limit the number of the channels of the second layer wiring. That is, be increasing or decreasing the number of the channels of the second layer wiring within the region of the element group of one basic unit, the size of the fundamental transistor element can be optimized with respect to the target horizontal direction may be optimized depending on the requirements of the layout system.

In the above-described embodiments, in addition, the second layer wirings are formed having only one fixed length in the horizontal direction, but the application of this invention does not limit the length of the second layer wirings, and it may be possible to use mixed second layer wirings of differing length.

Moreover, in the embodiments described above, the CMOS type semiconductor integrated circuits are mentioned, but this invention may similarly be embodied in NMOS, PMOS, bipolar, Bi-CMOS, GaAs, ECL and other master slice type integrated circuit devices using a different process or device, exactly in the same manner as in the CMOS type.

In the foregoing description of the embodiment shown in Figs. 7 to 9 , transistor elements were stated as the semiconductor elements to be formed on substantially the entire surface of the semiconductor substrate, but the application of this invention is not limited to the use transistor elements alone. In other words, among the group of known semiconductor elements that can be formed on a semiconductor substrate, all are applicable to the invention. For example, besides transistor elements, capacitative elements and resistive elements are also applicable. Furthermore, this invention is also applicable to the so-called analog master slice type integrated device which mixes transistor elements, capacitative elements resistive elements, and others.

Although in the master slice type integrated circuit device according to the above described embodiments, wiring by means of two conductive wiring layers is disclosed, the effects of this invention is not limited by the number of wiring layers.

This invention is thus intended to realize a final circuit by wiring only the top layer depending on the individual desired circuit. This is achieved by forming a master slice by finishing the process up to formation of lower layer wiring pieces and contact holes formed in the insulation layer thereon on an already diffused semiconductor substrate. Therefore, the steps up to the step of forming contact holes may be carried out during manufacture regardless of the desired final circuits, so that mass production is possible, and the final products can be completed by forming wiring on the uppermost layer thereof depending on the requirements of the users. Accordingly, the invention is applicable to a wide variety of products, and the term for development and manufacture of such circuits can be greatly shortened.

## Claims

1. A master slice type integrated circuit device comprising
a repetitive pattern of basic cell units, each basic cell unit comprising:
an area of a semiconductor substrate including at least one transistor element (70 to 85, 110 to 129, 150 to 169, 200a to 205);
a first insulation layer formed on said area of semiconductor substrate;
a first wiring layer formed on said first insulation layer and comprising a regular array of first ones of first layer wiring pieces (88, 132, 174, 213) and second ones of first layer wiring pieces (89, 133, 175, 214), all said wiring pieces being discrete, elongate metal elements which are parallel to each other and extend in a first direction,
the length of said wiring pieces being chosen that two of the first ones of the first layer wiring pieces may extend along a second one of the first layer wiring pieces, and the respective pitch of the basic cell units along said first direction allowing for the arrangement of at least one of the second ones of the first layer wiring pieces within the pitch; and
a second insulation layer formed on said first wiring layer;
wherein said first insulation layer contains a plurality of through holes (88b 212) positioned beneath first ends of said first ones of first layer wiring pieces, through which said first ones of first layer wiring pieces are connected to said transistor elements, and said second insulation layer contains a plurality of contact holes (88a, 208) positioned above second ends of said first ones of first layer wiring pieces and above both ends of said second ones of first layer wiring pieces, whereby contact may selectively be made to said first layer wiring pieces by the formation of second layer wirings (92, 94,...134, 136,...100, 182,... 206a, 206b...) on said second insulation layer;
wherein all said contact holes are formed along at least two first tracks (90) which are parallel to each other and orthogonal to said first direction, and said through holes are formed along at least two second tracks (91) spaced from and parallel to said first tracks (90) which contain said contact holes (88a, 208); and wherein said first and second tracks (90, 91) extend in undeviated alignment across boundaries between adjacent basic cell units.

2. A master slice type integrated circuit device according to claim 1, wherein said first wiring layer further comprises power source wirings (86, 87, 130, 131, 172, 173) extending in the first direction through the basic cell units, and wherein said second insulation layer contains further contact holes positioned above said power source wirings and aligned with said first tracks (90), whereby contact may selectively be made to said power source wirings.

3. A method of manufacturing an integrated circuit device making use of a master slice type integrated circuit device as defined in claims 1 and 2 comprising the step of forming a second wiring layer on the second insulating layer, the second wiring layer comprising elongate second layer wirings (206) on said second insulation layer, each having a main elongate portion extending in a second direction orthogonal to said first direction, and having branch portions extending in said first direction, the main portion being located between said first tracks (90) of a basic cell unit, and connecting selected second layer wirings to selected first layer wiring pieces by means of said branch portions extending over said contact holes.

4. A method according to claim 3, wherein there is sufficient space between said first tracks (90) of a basic cell unit for two elongate second layer wirings.

5. A method according to claims 3 or 4, wherein said second wiring layer additionally comprises further second layer wirings overlapping contact holes.

## Patentansprüche

1. Intergriertes Schaltkreis-Bauelement vom Typ Master-Slice, das umfaßt:
ein sich wiederholendes Muster aus Grundzelleneinheiten, wobei jede Grundzelleneinheit umfaßt:
eine Zone eines Halbleitersubstrats, die wenigstens ein Transistorelement (70 bis 85, 110 bis 129, 150 bis 169, 200a bis 205) enthält;
eine erste auf der Zone des Halbleitersubstrats gebildete Isolierschicht;
eine erste Verdrahtungslage, die auf der ersten Isolierschicht gebildet ist und eine regelmäßige Anordnung von ersten von Erstlagen-Verdrahtungsstücken (88, 132, 174, 213) und zweiten von Erstlagen-Verdrahtungsstücken (89, 133, 175, 214) umfaßt, wobei alle diese Verdrahtungsstücke einzelne längliche Metallelemente sind, die parallel zueinander liegen und in einer ersten Richtung verlaufen,
wobei die Länge dieser Verdrahtungsstücke gewählt ist, daß zwei der ersten der Erstlagen-Verdrahtungsstücke entlang einem zweiten der Erstlagen-Verdrahtungsstücke verlaufen können und der jeweilige Abstand der Grundzelleneinheiten entlang der ersten Richtung die Anordnung von wenigstens einem der zweiten der Erstlagen-Verdrahtungsstücke innerhalb des Abstandes erlaubt, und
eine zweite auf der ersten Verdrahtungslage gebildete Isolierschicht;
worin die erste Isolierschicht eine Mehrzahl unter ersten Enden der ersten der Erstlagen-Verdrahtungsstücke angeordneter Durchgangslöcher (88b, 212) enthält, durch die die ersten der Erstlagen-Verdrahtungsstücke mit den Transistorelementen verbunden werden, und die zweite Isolierschicht eine Mehrzahl über zweiten Enden der ersten der Erstlagen-Verdrahtungsstücke und über beiden Enden der zweiten der Erstlagen-Verdrahtungsstücke angeordneter Kontaktlöcher (88a, 208) enthält, wodurch ein Kontakt mit den Erstlagen-Verdrahtungsstücken durch die Bildung von Zweitlagen-Verdrahtungen (92, 94,...134, 136,...100, 182, ...206a, 206b...) auf der zweiten Isolierschicht selektiv hergestellt werden kann;
worin alle diese Kontaktlöcher entlang von wenigstens zwei ersten Spuren (90) gebildet sind, die parallel zueinander und rechtwinklig zu der ersten Richtung liegen, und die Durchgangslöcher entlang von wenigstens zwei zweiten Spuren (91) gebildet sind, die beabstandet und parallel zu den ersten Spuren (90) liegen, die die Kontaktlöcher (88a, 208) enthalten, und worin die ersten und zweiten Spuren (90, 91) in nicht abweichender Ausrichtung über die Grenzen zwischen benachbarten Grundzelleneinheiten hinweg verlaufen.

2. Intergriertes Schaltkreis-Bauelement vom Typ Master-Slice nach Anspruch 1, bei dem die erste Verdrahtungslage weiter Stromquellenleitungen (86, 87, 130, 131, 172, 173) umfaßt, die in der ersten Richtung durch die Grundzelleneinheiten verlaufen, und bei dem die zweite Isolierschicht weitere Kontaktlöcher enthält, die über den Stromquellenleitungen angeordnet und mit den ersten Spuren (90) ausgerichtet sind, wodurch ein Kontakt mit den Stromquellenleitungen selektiv hergestellt werden kann.

3. Verfahren zur Herstellung eines integrierten Schaltungs-Bauteils, das von einem intergrierten Schaltkreis-Bauelement vom Typ Master-Slice, wie in den Ansprüchen 1 und 2 definiert, Gebrauch macht, umfassend den Schritt zur Bildung einer zweiten Verdrahtungslage auf der zweiten Isolierschicht, wobei die zweite Verdrahtungslage längliche Zweitlagen-Verdrahtungen (206) auf der zweiten Isolierschicht umfaßt, wobei jede einen länglichen Hauptteil besitzt, der in einer zweiten Richtung rechtwinklig zu der ersten Richtung verläuft, und Verzweigungsteile besitzt, die in der ersten Richtung verlaufen, wobei der Hauptteil zwischen den ersten Spuren (90) einer Grundzelleneinheit gelegen ist und ausgewählte Zweitlagen-Verdrahtungen mit ausgewählten Erstlagen-Verdrahtungsstücken über die Verzweigungsteile, die sich über die Kontaktlöcher erstrecken, verbindet.

4. Verfahren nach Anspruch 3, bei dem zwischen den ersten Spuren (90) einer Grundzelleneinheit genügend Raum für zwei längliche Zweitlagen-Verdrahtungen vorhanden ist.

5. Verfahren nach Anspruch 3 oder 4, bei dem die zweite Verdrahtungslage zusätzlich weitere Zweitlagen-Verdrahtungen umfaßt, die sich über Kontaktlöcher erstrecken.

## Revendications

1. Dispositif de circuit intégré du type sur tranche prédiffusée comprenant :
un motif répétitif d'unités de cellule de base, chaque unité de cellule de base comprenant :
une zone d'un substrat semiconducteur incluant au moins un élément de transistor (70 à 85, 110 à 129, 150 à 169, 200a à 205) ;
une première couche d'isolation formée sur ladite zone du substrat semiconducteur ;
une première couche de câblage formée sur ladite première couche d'isolation et comprenant un réseau régulier de premières de premières pièces de câblage de couche (88, 132, 174, 213) et de secondes des premières pièces de câblage de couche (89, 133, 175, 214), toutes lesdites pièces de câblage étant discrètes, des éléments de métal allongés qui sont parallèles les uns aux autres et qui s'étendent suivant une première direction ;
la longueur desdites pièces de câblage étant choisie de telle sorte que deux des premières des premières pièces de câblage de couche puissent s'étendre le long d'une seconde des premières pièces de câblage de couche, et le pas respectif des unités de cellule de base suivant ladite première direction permettant l'agencement d'au moins l'une des secondes des premières pièces de câblage de couche dans le pas ; et
une seconde couche d'isolation formée sur ladite première couche de câblage ;
dans lequel ladite première couche d'isolation contient une pluralité de trous de passage (88b, 212) positionnés au-dessous de premières extrémités desdites premières des premières pièces de câblage de couche, au travers desquels lesdites premières des premières pièces de câblage de couche sont connectées auxdits éléments de transistor, et ladite seconde couche d'isolation contient une pluralité de trous de contact (88a, 208) positionnés au-dessus de secondes extrémités desdites premières des premières pièces de câblage de couche et au-dessus des deux extrémités desdites secondes des premières pièces de câblage de couche et ainsi, un contact peut être sélectivement établi avec lesdites premières pièces de câblage de couche au moyen de la formation de seconds câblages de couche (92, 94, 134, 136, ..., 100, 182, ..., 206a, 206b, ...) sur ladite seconde couche d'isolation ;
dans lequel tous lesdits trous de contact sont formés le long d'au moins deux premières pistes (90) qui sont parallèles l'une à l'autre et orthogonales à ladite première direction, et lesdits trous de passage sont formés le long d'au moins deux secondes pistes (91) espacées desdites premières pistes (90) et parallèles à celles-ci, lesquelles contiennent lesdits trous de contact (88a, 208) ; et dans lequel lesdites premières et secondes pistes (90, 91) s'étendent selon un alignement non dévié au travers des frontières entre des unités de cellule de base adjacentes.

2. Dispositif de circuit intégré du type sur tranche prédiffusée selon la revendication 1, dans lequel ladite première couche de câblage comprend en outre des câblages d'alimentation (86, 87, 130, 131, 172, 173) s'étendant suivant la première direction au travers des unités de cellule de base et dans lequel ladite seconde couche d'isolation contient des trous de contact supplémentaires positionnés au-dessus desdits câblages d'alimentation et alignés avec lesdites premières pistes (90) et ainsi, un contact peut être sélectivement établi avec lesdits câblages d'alimentation.

3. Procédé de fabrication d'un dispositif de circuit intégré utilisant un dispositif de circuit intégré du type sur tranche prédiffusée tel que défini dans les revendications 1 et 2, comprenant l'étape de formation d'une seconde couche de câblage sur la seconde couche d'isolation, la seconde couche de câblage comprenant des seconds câblages de couche allongés (206) sur ladite seconde couche d'isolation, chacun comportant une partie allongée principale s'étendant suivant une seconde direction orthogonale à ladite première direction, et comportant des parties de branchement s'étendant suivant ladite première direction, la partie principale étant positionnée entre lesdites premières pistes (90) d'une unité de cellule de base, et connectant des seconds câblages de couche choisis à des premiers éléments de câblage de couche choisis au moyen desdites parties de branchement s'étendant sur lesdits trous de contact.

4. Procédé selon la revendication 3, dans lequel il y a un espace suffisant entre lesdites premières pistes (90) d'une unité de cellule de base pour deux seconds câblages de couche allongés.

5. Procédé selon la revendication 3 ou 4, dans lequel ladite seconde couche de câblage comprend en outre des seconds câblages de couche supplémentaires chevauchant des trous de contact.
